# EUROPEAN PATENT SPECIFICATION

(11) **EP 3 722 461 B1**
(45) Date of publication and mention of the grant of the patent: **27.11.2024**
(21) Application number: 19169037.9
(22) Date of filing: 12.04.2019
(51) Int. Cl.: C23C 28/04, C23C 14/00, C23C 14/08, C23C 14/34, C23C 28/00, C23C 30/00, C23C 14/35

(54) **A COATED CUTTING TOOL**
BESCHICHTETES SCHNEIDWERKZEUG
OUTIL DE COUPE RECOUVERT

(43) Date of publication of application: 14.10.2020
(73) Proprietor: WALTER AG, 72072 Tübingen (DE); Eberhard Karls Universität Tübingen, 72074 Tübingen (DE)
(72) Inventor: PFEFFER, Michael, 71093 Well im Schönbuch (DE); EIBL, Oliver, 72138 KIRCHENTELLINSFURT (DE); ENGELHART, Wolfgang, DE-72555 Metzingen (DE)
(74) Representative: Sandvik

(56) References cited:
- EP-B1- 2 408 945
- WO-A1-2010/106142
- WO-A1-92/17623
- JP-A- 2005 262 356
- US-A- 5 516 588

## Description

The present invention relates to a coated cutting tool having a coating comprising a layer of aluminium oxide having a disordered crystal structure and being semiconductive.

### Introduction

There is a continuous desire to improve cutting tools for metal machining so that they last longer and/or withstand increasingly demanding cutting operations such as higher cutting speeds.

Generally cutting tools for metal machining comprises a substrate of a hard material such as cemented carbide, cubic boron nitride, or cermet, and a thin wear resistant coating deposited on the surface of the substrate.

The coating should ideally have a high hardness but at the same time posess sufficient toughness in order to withstand severe cutting conditions as long as possible.

Aluminium oxide (Al₂O₃) layers are used since a long time as part of wear resistant coatings on cutting tools.

Aluminium oxide is generally deposited with either a chemical vapour deposition (CVD) process or a physical vapour deposition (PVD) process. CVD and PVD coatings are different to each other in many respects, for example residual stress levels, density, hardness and surface properties.

Crystalline aluminium oxide has an ionic character which means that no free charge carrier is present resulting in electrically insulating properties and also a comparatively low heat conductivity which is good in metal cutting. However, the internal ionic bonds is also connected to a certain level of brittleness which would be desirable to reduce.

Furthermore, in a PVD process a so-called bias potential is generally applied to the substrates to be coated in order to achieve the surface energy and atomic mobility needed for the growth process. The energy is necessary to provide a crystalline structure in a growing layer. When applying insulating layers, of for example aluminium oxide, using a PVD process, the effectively applied bias potential is being reduced during the growth process with increased layer thickness. This is due to the insulating properties of the deposited material, which due to its electrically isolating properties worsens the growth conditions at the layer surface. Arcing is more prone to occur when continuing to depositing aluminium oxide onto a previously deposited insulating aluminium oxide leading to defects in the deposited material and can ultimately lead to deposition of an amorphous layer instead of a desired crystalline layer.

US 20110311805 A1 and Engelhart et al., Deposition of alumina thin film by dual magnetron sputtering: Is it γ-Al2O3", Acta Materialia 59 (2011), 7757-7767, discloses an aluminium oxide film containing Ar with an Ar to Al ratio being about 17. The maximum lattice spacing seen in electron diffraction is 2.04 Å. The aluminium oxide structure is a disordered structure referred to as a pseudo gamma phase. The patent document WO2010/106142 A1 discloses a coated cutting tool with an alumina layer which lattice is modified with a noble gas and that has high hardness.

Cremer R. et al., "Comparative characterization of alumina coatings deposited by RF, DC and pulsed reactive magnetron sputtering", Surface and Coatings Technology, vol. 120-121, November 1999, pages 213-218, describe investigations on the structure of PVD alumina coatings as a function of substrate temperature and deposition conditions. Crystalline gamma-Al₂O₃ films were deposited by reactive magnetron sputtering. The influence of deposition temperature and sputtering conditions upon the crystal structure of the films has been investigated by X-ray diffraction, the hardness by micro-indentation.

Bobzin K. et al., "Relation of hardness and oxygen flow of Al2O3 coatings deposited by reactive bipolar pulsed magnetron sputtering", Thin Solid Films, vol. 494, issue 1-2, pages 255-262, describe investigations about the influence of deposition parameters on the properties of alumina films. Different alumina structures were deposited by means of reactive bipolar pulsed magnetron sputtering. Crystalline gamma-Al₂O₃ were synthesized.

The resistivity of an insulator is independent of a change in temperature while the resistivity of a conductor increases with increased temperature. For a semi-conductor the resistivity decreases with increased temperature. This is due to that the number available electron for charge transport in a semi-conductor increases exponentially with increased temperature so the resistivity decreases accordingly.

The object of the present invention is to provide a coated cutting tool wherein the coating comprises an aluminium oxide layer with excellent mechanical properties such as high hardness and high elastic modulus giving high wear resistance. There is a further object of the present invention to provide an aluminium oxide layer which can be provided also as comparatively thick layers with maintained excellent mechanical properties.

### The invention

There are two general features which are the most relevant for the present invention: (i) a semiconductive aluminium oxide and (ii) an aluminium oxide with a disordered crystal structure. Electrical properties such as semiconductive properties are comparatively easy to measure. However, measurements on the crystal structure in order to get further detailed information, beyond crystal symmetry and compositional parameters, are difficult to make. However, the electrical properties depend strongly on bonding properties so if semiconductive properties are present they are a reflection to some extent of the crystal bonding properties. Such crystal bonding properties being diffult to detect by other analysis. Thus, in order to characterise the present invention there is a need for both electrical and diffraction analysis of the aluminium oxide phase. The present invention is therefore defined by features resulting from both electrical and diffraction analysis.

The disordered aluminium oxide structure can best be described as being an intermediate between an amorphous structure and a perfectly crystalline structure. The mechanical properties are strongly influenced by order and disorder. Since plastic deformation is influenced by crystalline defects, disorder puts friction to the movement of such defects and makes them less mobile. Furthermore, less ionic bonding influences the mechanical properties. All this has been found to yield increased mechanical strength of the present aluminium oxide layer.

An insulating material has a high resistivity and a conductive material has a low resistivity. A semi-conductive material has an intermediate resistivity.

The resistivity of a conductor decreases with decreasing temperature. However, the resistivity of a semi-conductive material increases exponentially by decreasing temperature. Instead of describing the complete exponential function, i.e., calculating the band gap energy, the degree of temperature dependence of resistivity (ρ) can be described by a "resistivity ratio", which is herein defined as a ratio between the resistivity at a temperature of 80 K and the resistivity at a temperature of 300 K. The range of such a resistivity ratio p(80K)/ p(300K) should always be >1 for a semi-conductive material. The absolute value of electrical resistance at room temperature for the layer of aluminium oxide depends on the physical size and geometry of the layer and the substrate onto which is deposited. The resistivity ratio, on the other hand, is independent of such factors and can thus be used as a generally valid feature for an electrical property of the aluminium oxide.

It has now been provided a coated cutting tool according to claim 1 and comprising a substrate with a coating comprising a 0.1-20 µm thick layer of aluminium oxide which comprises one or more noble gas elements in an amount of greater than 0.7 at-%, the aluminium oxide has a grain structure in which there are present within a plurality of the existing grains structural disorders which are presented as that in electron diffraction images of the grains point-shaped reflections occur up to a maximum lattice plane spacing dLlMIT and for lattice plane spacings of greater than dLlMIT no point-shaped reflections occur, but an intensity distribution that is typical for amorphous structures, dLlMIT being > 1.990 Å and ≤ 2.500 Å, a lattice plane spacing d1 is present being from 1.990 to 2.050 Å, and wherein the layer of aluminium oxide has a resistivity ratio p(80K)/ p(300K) of > 1 and ≤ 10.

The lattice plane spacing d1 gives a reflection in 2theta XRD at about 45 degrees 2theta. Thus, d1 is suitably calculated from the precise 2theta position of this reflection.

Thus, it has been provided a coated cutting tool wherein the coating is semi-conductive and which allows for deposition of thicker films with sustained coating characteristics during deposition. Such coating characteristics may be the type- and/or level of crystallinity in the aluminium oxide and as a result the mechanical properties of the coating.

The aluminium oxide herein described comprises an aluminium oxide phase which is surprisingly semiconductive instead of being an insulator. Thus, the ionic character of the bonding is less than normal for aluminium oxide and the crystal structure is altered which lead to less brittleness, without any decreased hardness. Thus, there is provided an altered aluminium oxide structure which can be described by its semiconductive properties along with its electron diffraction pattern. The aluminium oxide also has a significant degree of transparency, or being substantially transparent despite the disordered structure and noble gas content.

Thus, by "aluminium oxide" is herein meant a compond containing aluminium, oxygen and atoms of a noble gas, the atomic fraction ratio of aluminium to oxygen is roughly 0.667 (2/3).

Electron diffraction in transmission electron microscopy (TEM) is the preferred method for analysing the crystal structure.

The intensity distribution typical for amorphous structures can also be referred to as diffuse.

Electron diffraction images of the grain structure according to the invention in the aluminium oxide layer were evaluated in respect of the intensity/ d-values (lattice plane spacings) and for the crystal structure according to the invention involving disorder in respect of the grains of the aluminium oxide layer it was found that point-shaped reflections occurred only up to a given d-value (dLlMIT) while for greater lattice plane spacings d (lower scatter angles) above the dLlMIT there are no point-shaped reflections observed, but rather there was a diffuse intensity distribution, as is typical for amorphous structures. Upon a comparison between the experimentally obtained d-values and the d-values to be expected for known aluminium oxide structures (see for example Acta Cryst. B47 (1991) 617-630, or ICDD database) it was established that the reflections which should have d-values of greater than dLlMIT were missing. With lattice plane spacings greater than dLlMIT at least one reflection which would be expected from an ordered structure of the same compound was missing in the diffraction image of the structure according to the invention.

If reference is made herein to a plurality of the existing grains which have the structure according to the invention, that means a predominant number in relation to other grains in the same layer, over 50% of the total number of grains, particularly preferably over 70% of the total number of grains and quite particularly preferably over 90% of the total number of grains.

In one embodiment the value of dLlMIT is > 2.000 Å and ≤ 2.300 Å.

The lattice plane spacing d1 is suitably from 1.995 to 2.045 Å, preferably from 2.000 to 2.040 Å.

dLlMIT is greater than the lattice plane spacing d1.

The disordered aluminium oxide is furthermore semi-conductive instead of being an insulator which provides for a potential for performance advantages as a wear resistant coating. This is because the altered electrical properties reflect a structural change from a conventional aluminium oxide structure in that it has less ionic character which implies less brittleness which would expected to be a benefit in metal cutting.

The layer of aluminium oxide suitably comprises one or more noble gas elements in an amount of greater than 0.8 at-%.

The layer of aluminium oxide suitably comprises one or more noble gas elements in an amount from 0.7 to 5 at-%, or from 0.8 to 3 at-%.

The layer of aluminium oxide comprises one or more noble gas elements suitably having an in-depth distribution of content in the layer.

The one or more noble gas elements is one or more of Ar, Kr, Ne, Xe and He, preferably one or both of Ar and Kr, most preferably Ar.

The aluminium oxide layer has a resistivity ratio p(80K)/ p(300K) from 2 to 7, preferably from 3 to 6.

Semi-conductive properties of a deposited aluminium oxide layer may be an advantage in a PVD deposition process since it enables better biasing and therefore thicker coatings of consistent structure may be provided.

The semiconductive aluminium oxide layer has also been found to present excellent mechanical properties such as lower brittleness than a conventional aluminium oxide being an insulator. The improved mechanical properties is expected to be beneficial when the semiconductive aluminium oxide layer is used in a coating for cutting tools for metal machining.

The layer of aluminium oxide suitably has a Vickers hardness of 2400-3000 HV, preferably 2600-3000 HV.

The layer of aluminium oxide suitably has a reduced Young's modulus of 320-400 GPa, preferably 340 to 400 GPa.

The thickness of the aluminium oxide layer is suitably 0.2-10 µm, preferably 0.5-5 µm.

The aluminium oxide layer of the coating is preferably a PVD layer, i.e., it has been deposited by a PVD process, suitably magnetron sputtering, preferably reactive magnetron sputtering, most preferably reactive dual magnetron sputtering.

In one embodiment the coating comprises a combination of the aluminium oxide layer and a layer of a metal nitride, metal carbide or metal carbonitride, being a nitride, carbide or carbonitride of one or more metals belonging to group 4 to 6 in the IUPAC periodic table of elements, optionally together with Al, Si and/or B. The metal nitride, metal carbide or metal carbonitride is preferably a nitride, carbide or carbonitride of one or more metals belonging to Ti, Cr, Zr, optionally together with Al and/or Si. Most preferably the coating comprises a combination of the aluminium oxide layer and a layer of a nitride of one or more metals belonging to Ti, Cr, Zr, optionally together with Al and/or Si.

The metal nitride, metal carbide or metal carbonitride layer is preferably a PVD layer, i.e., it has been deposited by a PVD process, preferably magnetron sputtering, most preferably reactive magnetron sputtering or HIPIMS.

In one embodiment the coating comprises a combination of the aluminium oxide layer and a metal or metal alloy layer of one or more metals belonging to group 4 to 6 in the IUPAC periodic table of elements, optionally together with Al, Si and/or B. The metal is preferably one or more metals belonging to Ti, Cr, Zr, optionally together with Al.

The layer of metal, or metal nitride, metal carbide or metal carbonitride can be positioned beneath the aluminium oxide layer, i.e., between the aluminium oxide layer and the substrate. The layer of metal, or metal nitride, metal carbide or metal carbonitride can also alternatively be positioned above the aluminium oxide layer.

The substrate of the coated cutting tool can be of any kind common in the field of cutting tools for metal machining. Substrates include cemented carbide, cermet, cBN, ceramics, PCD and HSS.

In one embodiment, the substrate is cemented carbide.

The coated cutting tool can be a coated cutting insert, such as a coated cutting insert for turning or a coated cutting insert for milling, or a coated cutting insert for drilling, or a coated cutting insert for threading, or a coated cutting insert for parting and grooving. The coated cutting tool can also be a coated solid drill, an endmill, or a tap.

### Brief description of the drawings

Fig.1 shows a set-up for the electrical measurements
Fig.2 shows a plot of the Ar content and the lattice plane spacing calculated from the reflection at about 45 degrees 2theta
Fig.3 shows an electron diffraction image for a layer of aluminium oxide according to the invention
Fig. 4 shows a resistance-temperature plot of a sample according to the invention

### Methods

### Noble gas content:

The noble gas content (Ar in the examples) was measured by using Scanning Electron Microscopy (SEM) with Energy Dispersive X-Ray Spectroscopy (EDX) on a cross section prepared sample. For SEM imaging and EDX analysis, a Philips XL 30 instrument was used, equipped with a field emission gun, secondary electron-dectector and Si(Li) energy dispersive x-ray (EDX) detector from Oxford Instruments. The acceleration voltage was set to 10kV for EDX point spectra acquisition and 15kV for EDX line scan acquisition. To guarantee reproducible and comparable results, the different samples were always mounted in the same orientation with respect to the EDX detector. The electron beam is positioned in the middle of a cross section of the film and spectra are recorded at least at three different positions in the cross section with one to three spectra taken at every position.

### Hardness and reduced Young's modulus:

The mechanical properties hardness and (reduced) Young's modulus were measured by nano indentation measurements using a Fischer HM500 equipment using a Vickers indentation tip. The samples were mirror polished using a 1 µm polishing suspension. The hardness values were calculated from the maximum load divided by the contact area of the indenter The load was increased continuously for 20 s up to a maximum load of 15 mN. After a creep time of 10 s the load was decreased within 20 s.

### X-Ray Diffraction:

The X-ray diffraction patterns were acquired by Grazing incidence mode (GIXRD) on a diffractometer from Panalytical (Empyrean). Cu-Kα-radiation with line focus was used for the analysis (high tension 40 kV, current 40 mA). The incident beam was defined by a 2 mm mask and a 1/8° divergence slit in addition with a X-ray mirror producing a parallel X-ray beam. The sideways divergence was controlled by a Soller slit (0.04°). For the diffracted beam path a 0,18° parallel plate collimator in conjunction with a proportional counter (0D-detector) was used. The measurement was done in grazing incidence mode (Omega = 1°). The 2theta range was about 20-80° with a step size of 0.03° and a counting time of 10 s.

### Electron diffraction in transmission electron microscopy (TEM)

In the electron diffraction analysis made herein these are TEM measurements which were carried out using a Transmission Electron Microscope: Zeiss 912 Omega High tension 120 kV ). 10 eV energy slit aperture was used. Only the coating should contribute to the diffraction pattern by using a selected area aperture. The TEM was operated with parallell illumination for the diffraction (SAED).

To rule out an amorphisation during sample preparation different methods can be used, i) classical preparation including mechanical cutting, gluing, grinding and ion polishing and ii) using a FIB to cut the sample and make a lift out to make the final polishing.

### Resistivity measurements

The resistivity values were herein measured in cross-plane of the coating. Since one cannot soldering on alumina it was applied a conductive coating on top of the oxide being a 40 nm Au metallization layer. Alternatively a TiAIN coating, which is conductive, can be used, suitable 300-600 nm thick. A preferred way of depositing such a TiAIN is by using HIPIMS, since it is important to have a dense and defect free coating for the electrical measurements.

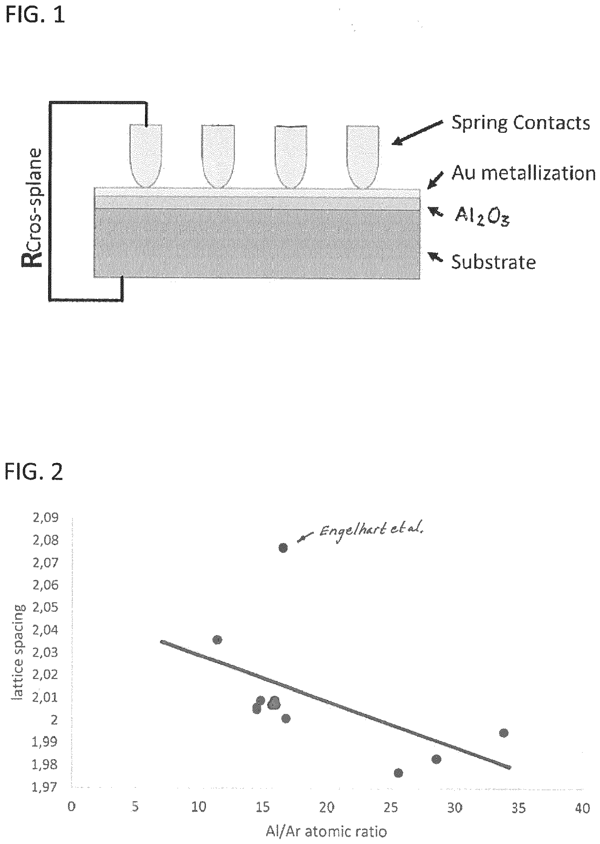

Spring contacts are then lowered to the Au metallization (or the TiAIN layer) and the resistance is measured between the top and the bottom of the sample (bottom of the substrate). See set-up is shown in Fig. 1. A resistance value was determined by measuring the current during a voltage sweep from 0 mV to 20 mV.

For obtaining the temperature dependency measurements were made in a cryostat in which a sample to be measured was put. Measurements were made between 80 and 300 K.

### Examples

### Example:

### Samples 1-11:

Thin films of aluminium oxide were deposited onto on mirror-polished cemented carbide (WC-Co-based) substrates (8 wt% Co) by reactive dual magnetron sputtering (DMS) in a Hauzer HTC1000 equipment. Two unbalanced magnetrons with pure metallic aluminium targets were used.

The following process parameters/conditions were used:

| | |
|---|---|
| Ar-pressure: | 0.5 Pa |
| O₂-pressure: | 0.1 Pa |
| Substrate temperature: | 550°C |
| Average target power: | 6 W/cm² |
| Power density in plasma | 0.1 W/m³ |
| Bias voltage: | -125 V DC (pulsed 100 kHz, 2 µs off-time) |
| Target size: | 81.5 × 16 cm |
| Deposition time: | 2 h |

Samples 2 and 3 having the worst mechanical properties were made in a reactor which was due for maintenance, i.e., there were a lot of deposits on various parts inside the reactor. This effects the deposition conditions and control of the process. This will affect for example the amount of and efficiency of incorporation of Ar into the layer. Also, the end result of the coating in terms of for example mechanical properties are affected. The samples 4-11 having the best mechanical properties were made in a recently maintained reactor enabling a controlled process. Thus, the deposition parameters mentioned above are valid for a PVD reactor which is properly maintained in order to obtain a layer according to the invention. The "worse" samples were incidently produced and are used herein for comparison purposes.

The layer thickness on the samples were measured and ranged between 0.36 and 1.76 µm.

The Ar content in the aluminium oxide layers was determined by using SEM-EDX.

The hardness and reduced Young's modulus of the deposited aluminium oxide layers were determined.

XRD analysis were made on the samples. From the position of the peak at about 45 degrees 2theta (can also be seen as to a certain extent corresponding to the "(400)" peak for gamma aluminium oxide) the corresponding lattice plane spacing d1 for the different samples was determined.

The results are seen in Table 1.

**Table 1.**

| Sample No. | Sample ID | Thickness of alumina film (µm) | Ar content (at-%) | Al/Ar atomic ratio | XRD 2theta peak position (degrees) | Lattice plane spacing d1 calculated from the peak position (Å) |
|---|---|---|---|---|---|---|
| 1 | S1S1 | 0.76 | 0.89 | 33.8 | 45.47 | 1.995 |
| 2 | S1S2 | 1.47 | 1.09 | 28.6 | 45.76 | 1.983 |
| 3 | S1S3 | 1.64 | 1.29 | 25.6 | 45.90 | 1.977 |
| 4 | S3S1 | 1.64 | 1.87 | 16.0 | 45.19 | 2.007 |
| 5 | S3S2 | 0.65 | 2.08 | 14.5 | 45.23 | 2.005 |
| 6 | S3S3 | 1.28 | 2.03 | 14.8 | 45.14 | 2.009 |
| 7 | S3S4 | 0.56 | 1.84 | 15.7 | 45.18 | 2.007 |
| 8 | S2S1 | 1.76 | 2.09 | 15.6 | 45.13 | 2.009 |
| 9 | S2S2 | 0.88 | 1.93 | 16.8 | 45.33 | 2.001 |
| 10 | S2S3 | 0.66 | 3.04 | 11.4 | 44.50 | 2.036 |
| 11 | S2S4 | 0.36 | 2.57 | 14.5 | 45.21 | 2.006 |

The relation between Al/Ar atomic ratio and the lattice plane spacing d1 for the reflection at about 45 degrees 2theta is shown in Fig. 2. The figure also includes the sample disclosed in Engelhart et al., "Deposition of alumina thin film by dual magnetron sputtering: Is it γ-Al2O3", Acta Materialia 59 (2011), 7757-7767*.* It is concluded that for the same Ar content the d-spacing is smaller for a layer of the present invention than for the pseudo-gamma aluminium oxide layer disclosed in Engelhart et al. which means that the coatings are different.

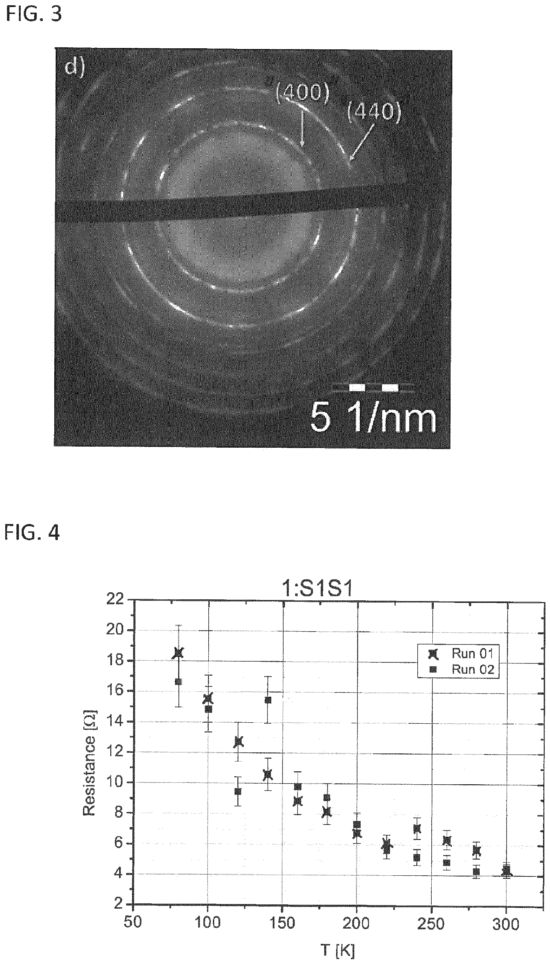

Fig. 3 shows a typical pattern from electron diffraction analysis of a layer of the present invention. It can be seen that no point-shaped reflections occur above a certain lattice plane spacing ("dLlMIT"). In this case dLlMIT is about 2.2 Å.

The electrical resistance at room temperature (300 K) of the deposited aluminium oxide layer was measured on the samples. For samples 1-7 a thin layer of Au was used as a conductive top layer. For samples 8-11 a TiAIN film of a thickness between 0.3-0.5 µm was used as a conductive top layer.

The electrical resistance at 80 K was also measured on sample 1 and samples 8-11 so that a resistivity ratio p(80K)/ p(300K) could be determined for these samples.

Fig. 4 shows a resistance-temperature plot for the complete measurement of sample 1. An exponential increase in resistance with decreasing temperature is seen which is typical for a semi-conductive material.

Furthermore, the hardness and reduced Young's modulus of the deposited aluminium oxide layers were determined for samples 1-7. Samples 8-11 were not specifically measured due to that a TiAIN coating was deposited on top of the aluminium oxide as a conducting layer for resistance measurements and indentation measurements were not possible. However, since the aluminium oxide deposition was made in a recently mainained reactor the mechanical properties should be good and the hardness is regarded to be >2600 HV as always obtained with the present process in a well-maintained reactor.

The results are seen in Table 2.

**Table 2.**

| Sample No. | Sample ID | Resistivity ratio, ρ(80K)/ ρ(300K) | Resistance* at room temp (300K) (Ω) | Resistance* at 80 K (Ω) | Reduced Young's Modulus (GPa) | Hardness (HV) |
|---|---|---|---|---|---|---|
| 1 | S1S1 | 4.3 | 11.9 | 51 | 323 | 2300 |
| 2 | S1S2 | | 45.4 | | 270 | 1600 |
| 3 | S1S3 | | 122 | | 271 | 1900 |
| 4 | S3S1 | | 10.1 | | 352 | 2900 |
| 5 | S3S2 | | 7.8 | | 352 | 2900 |
| 6 | S3S3 | | 11.6 | | 343 | 2600 |
| 7 | S3S4 | | 9.0 | | 343 | 2600 |
| 8 | S2S1 | 1.8 | 57 | 103 | | >2600 |
| 9 | S2S2 | 1.9 | 260 | 494 | | >2600 |
| 10 | S2S3 | 1.8 | 230 | 414 | | >2600 |
| 11 | S2S4 | 3.4 | 683 | 2322 | | >2600 |

| | | | | | | |
|---|---|---|---|---|---|---|
| * the resistance depends on the substrate which means that the absolute values of resistance between samples 1-7 on one hand and samples 8-11 on the other hand, cannot be related | | | | | | |

## Claims

1. A coated cutting tool comprising a substrate of cemented carbide, cermet, cBN, ceramics, PCD or HSS, with a coating comprising a 0.1-20 µm thick layer of aluminium oxide which comprises one or more noble gas elements in an amount of from 0.7 to 5 at-%, the one or more noble gas elements is one or more of Ar, Kr, Ne, Xe and He, the aluminium oxide has a grain structure in which there are present within over 50% of the total number of grains structural disorders which are presented such as in electron diffraction images of the grains point-shaped reflections occur up to a maximum lattice plane spacing dLlMIT and for lattice plane spacings of greater than dLlMIT no point-shaped reflections occur, but an intensity distribution that is typical for amorphous structures, dLlMIT being > 1.990 Å and ≤ 2.500 Å, dLlMIT is greater than the lattice plane spacing d1, a lattice plane spacing d1 is present being from 1.990 to 2.050 Å, and wherein the layer of aluminium oxide has a resistivity ratio p(80K)/ p(300K) of from 3 to 7, the noble gas content is measured by using Scanning Electron Microscopy (SEM) with Energy Dispersive X-Ray Spectroscopy (EDX) on a cross section prepared sample, the lattice plane spacing d1 gives a reflection in 2theta XRD at about 45 degrees 2theta and d1 is calculated from the precise 2theta position of this reflection, and the resistivity values at 80K and 300 K were herein measured in cross-plane of the coating, it was applied a conductive coating on top of the oxide being a 40 nm Au metallization layer, alternatively a TiAIN coating, suitably 300-600 nm thick, spring contacts are then lowered to the Au metallization, or the TiAIN layer, and the resistance is measured between the top and the bottom of the sample, a resistance value is determined by measuring the current during a voltage sweep from 0 mV to 20 mV.

2. A coated cutting tool according to claim 1, wherein the layer of aluminium oxide comprises one or more noble gas elements in an amount of from 0.8 to 3 at-%.

3. A coated cutting tool according to any one of claims 1-2, wherein the one or more noble gas elements is one or both of Ar and Kr.

4. A coated cutting tool according to any one of claims 1-3, wherein the lattice plane spacing d1 is 1.995 to 2.045 Å, preferably from 2.000 to 2.040 Å.

5. A coated cutting tool according to any one of claims 1-4, wherein the layer of aluminium oxide has a Vickers hardness of 2400-3000 HV.

6. A coated cutting tool according to any one of claims 1-5, wherein the layer of aluminium oxide has a reduced Young's modulus of 320-400 GPa.

7. A coated cutting tool according to any one of claims 1-6, wherein the thickness of the aluminium oxide layer is 0.2-10 µm.

8. A coated cutting tool according to any one of claims 1-7, wherein the aluminium oxide layer of the coating is a PVD layer deposited by dual magnetron sputtering.

## Patentansprüche

1. Beschichtetes Schneidwerkzeug mit einem Substrat aus Hartmetall, Cermet, cBN, Keramik, PKD oder HSS, mit einer Beschichtung, die eine 0,1 bis 20 µm dicke Schicht aus Aluminiumoxid umfasst, die ein oder mehrere Edelgaselemente in einer Menge von 0,7 bis 5 At.-% umfasst, wobei das eine oder die mehreren Edelgaselemente eines oder mehrere von Ar, Kr, Ne, Xe und He sind, das Aluminiumoxid eine Kornstruktur aufweist, wobei innerhalb von mehr als 50 % der Gesamtzahl der Körner Strukturstörungen vorhanden sind, die wie in Elektronenbeugungsbildern der Körner präsentiert sind, punktförmige Reflexionen bis zu einem maximalen Gitterebenenabstand dLIMIT auftreten und für Gitterebenenabstände größer als dLIMIT keine punktförmigen Reflexionen auftreten, aber eine Intensitätsverteilung, die für amorphe Strukturen typisch ist, wobei dLIMIT > 1,990 Å und < 2,500 Ä ist, dLIMIT größer als der Gitterebenenabstand d1 ist, ein Gitterebenenabstand d1 von 1,990 bis 2,050 Å vorhanden ist, und wobei die Schicht aus Aluminiumoxid ein Resistivitätsverhältnis p(80 K)/p(300 K) von 3 bis 7 aufweist, der Edelgasgehalt unter Verwendung der Rasterelektronenmikroskopie (REM) mit energiedispersiver Röntgenspektroskopie (EDX) an einer im Querschnitt präparierten Probe gemessen wird, der Gitterebenenabstand d1 eine Reflexion in 2theta XRD bei etwa 45 Grad 2theta ergibt und d1 anhand der präzisen 2theta-Position dieser Reflexion berechnet wird und die Resistivitätswerte bei 80 K und 300 K hierin in der Kreuzebene der Beschichtung gemessen wurden, eine leitfähige Beschichtung über dem Oxid aufgebracht wurde, die eine Au-Metallisierungsschicht von 40 nm ist, alternativ eine TiAIN-Beschichtung, geeigneterweise mit einer Dicke von 300 bis 600 nm, Federkontakte dann auf die Au-Metallisierung oder die TiAIN-Schicht abgesenkt werden und der Widerstand zwischen der Oberseite und der Unterseite der Probe gemessen wird, wobei ein Widerstandswert durch Messung des Stroms während eines Spannungsdurchlaufs von 0 mV bis 20 mV bestimmt wird.

2. Beschichtetes Schneidwerkzeug nach Anspruch 1, wobei die Schicht aus Aluminiumoxid ein oder mehrere Edelgaselemente in einer Menge von 0,8 bis 3 At.-% umfasst.

3. Beschichtetes Schneidwerkzeug nach einem der Ansprüche 1 bis 2, wobei das eine oder die mehreren Edelgaselemente eines oder beide von Ar und Kr sind.

4. Beschichtetes Schneidwerkzeug nach einem der Ansprüche 1 bis 3, wobei der Gitterebenenabstand d1 1,995 bis 2,045 Å, vorzugsweise 2,000 bis 2,040 Å, beträgt.

5. Beschichtetes Schneidwerkzeug nach einem der Ansprüche 1 bis 4, wobei die Schicht aus Aluminiumoxid eine Vickers-Härte von 2400 bis 3000 HV aufweist.

6. Beschichtetes Schneidwerkzeug nach einem der Ansprüche 1 bis 5, wobei die Schicht aus Aluminiumxoid einen reduzierten Elastizitätsmodul von 320 bis 400 GPa aufweist.

7. Beschichtetes Schneidwerkzeug nach einem der Ansprüche 1 bis 6, wobei die Gesamtdicke der Aluminiumoxidschicht 0,2 bis 10 µm beträgt.

8. Beschichtetes Schneidwerkzeug nach einem der Ansprüche 1 bis 7, wobei die Aluminiumoxidschicht der Beschichtung eine PVD-Schicht ist, die durch Doppelmagnetron-Sputtern abgeschieden wurde.

## Revendications

1. Outil de coupe revêtu comprenant un substrat de carbure cémenté, cermet, cBN, céramique, PCD ou HSS, avec un revêtement comprenant une couche d'oxyde d'aluminium d'une épaisseur de 0,1 à 20 um qui comprend un ou plusieurs éléments de gaz noble en une quantité de 0,7 à 5 % atomiques, les un ou plusieurs éléments de gaz noble sont un ou plusieurs parmi Ar, Kr, Ne, Xe et He, l'oxyde d'aluminium a une structure de grains dans laquelle sont présents au sein de plus de 50 % du nombre total de grains des désordres structurels qui sont présentés comme tels dans des images de diffraction d'électrons des réflexions ponctuelles de grains, qui se produisent jusqu'à un espacement maximal de plan réticulaire dLIMIT et pour des espacements de plan réticulaire supérieurs à dLIMIT aucune réflexion ponctuelle ne se produit, mais une distribution d'intensité qui est typique pour les structures amorphes, avec dLIMIT > 1,990 Å et ≤ 2,500 Å, dLIMIT est supérieur à l'espacement de plan réticulaire d1, un espacement de plan réticulaire d1 est présent qui est de 1,990 à 2,050 Å, et dans lequel la couche d'oxyde d'aluminium a un rapport de résistivité p(80K)/p(300K) de 3 à 7, la teneur en gaz noble est mesurée à l'aide de la microscopie électronique à balayage (MEB) avec la spectroscopie à rayons X à dispersion d'énergie (EDS) sur un échantillon préparé en coupe transversale, l'espacement de plan réticulaire d1 donne une réflexion en XRD 2thêta à environ 45 degrés 2thêta et d1 est calculé à partir de la position 2thêta précise de cette réflexion, et les valeurs de résistivité à 80K et 300K ont été mesurées dans le plan transversal du revêtement, on a appliqué un revêtement conducteur sur l'oxyde qui est une couche de métallisation d'Au de 40 nm, en variante un revêtement de TiAlN, de manière appropriée d'une épaisseur de 300 à 600 nm, des contacts à ressort sont alors abaissés jusqu'à la métallisation d'Au, ou la couche de TiAlN, et la résistance est mesurée entre le haut et le bas de l'échantillon, une valeur de résistance est déterminée par mesure du courant pendant un balayage de tension de 0 mV à 20 mV.

2. Outil de coupe revêtu selon la revendication 1, dans lequel la couche d'oxyde d'aluminium comprend un ou plusieurs éléments de gaz noble en une quantité de 0,8 à 3 % atomiques.

3. Outil de coupe revêtu selon l'une quelconque des revendications 1 et 2, dans lequel les un ou plusieurs éléments de gaz noble sont l'un ou les deux parmi Ar et Kr.

4. Outil de coupe revêtu selon l'une quelconque des revendications 1 à 3, dans lequel l'espacement de plan réticulaire d1 est de 1,995 à 2,045 Å, de préférence de 2,000 à 2,040 Å.

5. Outil de coupe revêtu selon l'une quelconque des revendications 1 à 4, dans lequel la couche d'oxyde d'aluminium a une dureté Vickers de 2400 à 3000 HV.

6. Outil de coupe revêtu selon l'une quelconque des revendications 1 à 5, dans lequel la couche d'oxyde d'aluminium a un module de Young réduit de 320 à 400 GPa.

7. Outil de coupe revêtu selon l'une quelconque des revendications 1 à 6, dans lequel l'épaisseur de la couche d'oxyde d'aluminium est 0,2 à 10 µm.

8. Outil de coupe revêtu selon l'une quelconque des revendications 1 à 7, dans lequel la couche d'oxyde d'aluminium du revêtement est une couche PVD déposée par double pulvérisation cathodique magnétron.
